**Europäisches Patentamt**

**European Patent Office**

**Office européen des brevets**

(19)

(11) **EP 1 320 156 A1**

(12) **EUROPEAN PATENT APPLICATION**

(43) Date of publication:
**18.06.2003 Bulletin 2003/25**

(51) Int Cl.⁷: **H01S 5/0687**, G02B 6/12

(21) Application number: **01310417.9**

(22) Date of filing: **13.12.2001**

(84) Designated Contracting States:
**AT BE CH CY DE DK ES FI FR GB GR IE IT LI LU MC NL PT SE TR**
Designated Extension States:
**AL LT LV MK RO SI**

(71) Applicant: **Agilent Technologies, Inc. (a Delaware corporation)**
**Palo Alto, CA 94303 (US)**

(72) Inventors:
• **Harker, Andrew Thomas**
  **Ipswich, Suffolk IP4 5QE (GB)**

• **Park, Christopher Anthony**
  **Bacton, Stowmarket, Suffolk IP14 4LJ (GB)**

(74) Representative: **Coker, David Graeme et al**
  **Agilent Technologies UK Ltd,**
  **Legal Dept,**
  **Eskdale Road,**
  **Winnersh Triangle**
  **Wokingham, Berks RG41 5DZ (GB)**

(54) **Control loop apparatus and method therefor**

(57) A known configuration for detecting changes in wavelength of light from a semiconductor laser device comprises an etalon for directing light incident thereupon to a detector. In order to co-package the semiconductor laser device with the etalon requires a package that is substantially larger than a package for the semiconductor laser device alone. The present invention overcomes this problem by disposing a dispersion element (14) adjacent the laser device (12) where the dispersion element (14) has the property of being substantially smaller than the etalon allowing it to be co-packaged more conveniently. This dispersion element comprises a photonic crystal.

*Fig. 1*

EP 1 320 156 A1

# Description

The present invention relates to a control loop apparatus, for example of the type used to generate an error signal for controlling a wavelength of a laser device. The present invention also relates to a method of controlling a wavelength for the laser device.

In a fibre optic network, the wavelength of light used to communicate a signal is an important parameter. In particular, where Wavelength Division Multiplexing (WDM) systems are employed, different signals are communicated using respectively different wavelengths. Consequently, it is important to maintain accurately the different wavelengths in relation to components of the WDM system, for example multiplexers and demultiplexers, which add or remove wavelengths from the WDM system.

Typically, a semiconductor laser device is employed in a transmitter unit of the fibre optic network. The wavelength of light transmitted by the laser device can be accurately controlled by altering a parameter, for example temperature, of the laser device using a closed loop feedback circuit. In this example, in order to determine whether to heat or cool the laser device, and to what extent, to restore the wavelength of the laser device to a predetermined wavelength, an error signal needs to be generated in the feedback circuit.

Clearly, a wavelength dependent element is required in order for generation of the error signal to be possible. In this respect, the wavelength dependent element can employ interference or dispersion to provide wavelength dependence. In relation to the use of interference, one known apparatus employing a Fabry-Perot etalon is disclosed in US 5,825,792. This document discloses a relatively compact apparatus comprising a lens, a Fabry-Perot etalon and two photodiodes, the apparatus being small enough to be copackaged with a semiconductor laser in a standard "butterfly" or a Dual In-Line package as are known in the art. In the case of the etalon, but also for gratings, light is split and propagated over multiple paths of different lengths before recombination. Respective phases are accumulated over the multiple paths, the phases accumulated being wavelength-dependent. Consequently, the result of the recombination also depends upon wavelength.

The dimensions of the etalon depend upon a required resolving power, R, of the etalon; the resolving power is a measure of a minimum change of wavelength that can be detected. The resolving power, R, of the etalon is given by the following equation:

$$R = F \, \frac{2nd}{\lambda_o}$$

where:

F is the coefficient of finesse,

n is the refractive index of the etalon;
d is the thickness of the etalon, and
$\lambda_o$ is the functioning wavelength of the light.

As a practical example, in order to monitor a 100 GHz or 50 GHz channel spacing, at least one dimension of the etalon has to be approximately 1 mm or approximately 2 mm, respectively. Clearly, such dimensions are large compared with a typical dimension, for example length, of approximately 300μm for a semiconductor laser.

Hence, to copackage the semiconductor laser device with the wavelength etalon requires a package that is substantially larger than a package for the semiconductor laser device alone.

For a dispersion-based wavelength dependent element, one property of a material forming the element is the angle through which light refracted at a surface of the material is deviated as a function of the wavelength of the light. In the case of the wavelength dependent element being a glass prism, the resolving power, R, of the prism is given by the following equation:

$$R = b\frac{dn}{d\lambda}$$

Where:

b is a length of a base of the prism,
n is the refractive index of the prism, and
A is the wavelength of the light.

In all of the above examples of wavelength dependent elements, the resolving power, R, is proportional to a physical dimension of the wavelength dependent element. Consequently, as channel spacing in the fibre-optic network is reduced, the resolving power, R, of the wavelength dependent element needs to increase and therefore the physical dimension of the wavelength dependent element needs to increase as well.

According to a first aspect of the present invention, there is provided a control loop apparatus for a laser device, the apparatus comprising a source capable of emitting electromagnetic radiation at a desired wavelength within a range of wavelengths, a detector, a dispersion element disposed between the source and the detector, and a controller coupled to the source and the detector, characterised in that the dispersion element comprises a photonic crystal arranged to translate a change in wavelength of the electromagnetic radiation from the desired wavelength into a spatial deviation of the electromagnetic radiation, the detector being arranged to detect the spatial deviation and output a signal corresponding to a measure of the spatial deviation caused by the dispersion element and the controller being arranged to control a parameter of the source in response to the signal generated by the detector so as to maintain the electromagnetic radiation substantially at the desired wavelength.

The electromagnetic radiation may be between about 300 nm and 10 μm. Preferably, the electromagnetic radiation is between about 400 nm and 2μm. Most preferably, the electromagnetic radiation is between about 800 nm and 1700 nm.

Preferably, the detector comprises an array of sensors.

Preferably, the detector is arranged to detect a dispersion of the electromagnetic radiation by the dispersion element in response to a change in the wavelength of the electromagnetic radiation.

Preferably, the desired wavelength of the electromagnetic radiation emitted by the source is capable of varying and the control of the parameter of the source results in control of the desired wavelength of the electromagnetic radiation emitted by the source.

According to a second embodiment of the present invention, there is provided a use of photonic crystal in a control loop to control a wavelength of a source of electromagnetic radiation.

Preferably, the photonic crystal disperses electromagnetic radiation incident thereupon, the dispersed electromagnetic radiation being detectable as indicative of the wavelength of the source of electromagnetic radiation.

According to a third aspect of the present invention, there is provided a method of controlling a source capable of emitting electromagnetic radiation at a desired wavelength within a range of wavelengths in a control loop, the control loop comprising the source, a detector, a dispersion element disposed between the source and the detector, and a controller coupled to the source and the detector, the method comprising the steps of: causing the electromagnetic radiation emitted by the source to undergo a spatial deviation in response to a change in wavelength of the electromagnetic radiation from the desired wavelength, detecting the spatial deviation of the electromagnetic radiation, generating a signal corresponding to a measure of the spatial deviation caused by the dispersion element, and controlling a parameter of the source in response to the signal so as to maintain the electromagnetic radiation substantially at the desired wavelength, characterised in that the dispersion element comprises a photonic crystal.

At least one embodiment of the invention will now be described, by way of example only, with reference to the accompanying drawing, in which:-

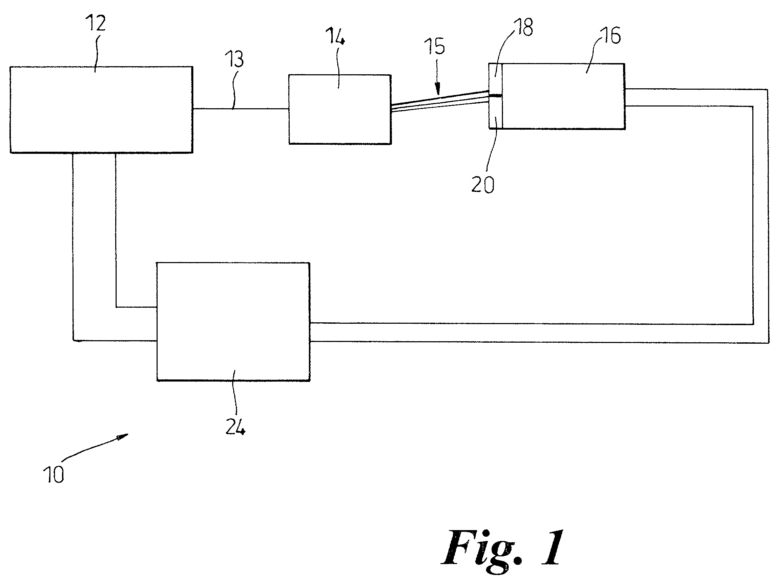

**Figure 1** is a schematic diagram of a laser wavelength locking control loop apparatus constituting a first embodiment of this invention.

Referring to Figure 1, a laser wavelength locking control loop 10 comprises a laser device 12, for example a tuneable semiconductor laser, disposed adjacent a dispersion element 14, for example, a photonic crystal such as a photonic crystal having a photonic band gap as disclosed in the Journal of Lightwave Technology, vol.17, no.11 1999, Hideo Kosaka *et al*. The dispersion element 14 is formed according to any suitable technique known in the art, for example by etching an array of holes into a suitable substrate material in order to form a photonic crystal structure. Disposed adjacent the dispersion element 14 is a detector 16 comprising a first photodiode 18 and a second photodiode 20. The detector 16 is coupled to a feedback controller circuit 24 which can be, but is not limited to, a proportional integral differential controller of a type known in the technical field. The feedback controller circuit 24 is coupled to the laser device 12.

In operation, the laser device 12 emits a first electromagnetic signal 13 at a wavelength λ within a range of wavelengths Δλ. The first electromagnetic signal 13 propagates through the dispersion element 14 and is deviated by the dispersion element 14, the deviation depending upon the wavelength λ and resulting in a deviated second electromagnetic signal 15. The deviated second electromagnetic signal 15 is incident upon the first and second photodiodes 18, 20 of the detector 16. The first photodiode 18 permits a first current to flow (not shown) and the second photodiode 20 permits a second current to flow in response to the deviated second electromagnetic signal 15 being incident upon the first and second photodiodes (18, 20) respectively. The first and second currents permitted to flow by the first and second photodiodes 18, 20 are at a ratio corresponding to the positions of incidence of the second electromagnetic signal 15 upon the first and second photodiodes 18, 20. The first electromagnetic signal 13 generated by the laser device 12 is considered to be at a correct wavelength within the range of wavelengths Δλ if the ratio of the first current to the second current is within a predetermined range of current ratios. The first electromagnetic signal 13 generated by the laser device 12 is considered to be at an incorrect wavelength within the range of wavelengths Δλ if the ratio of the first current to the second current is outside the predetermined range of current ratios.

The ratio of the first current to the second current is communicated as a feedback signal by the detector 16 to the feedback controller circuit 24. The feedback controller circuit 24 generates an error signal of substantially zero value in response to the feedback signal generated by the detector 16 if the first electromagnetic signal 13 is at the correct wavelength according to the above mentioned criterion. The feedback controller circuit 24 generates an error signal of non-zero value in response to the feedback signal generated by the detector 16 if the first electromagnetic signal 13 is at the incorrect wavelength according to the above mentioned criterion. The error signal generated by the feedback controller circuit 24 is processed by the feedback controller circuit 24 in order to generate a control signal for altering a parameter of the laser device 12, such as temperature; control of temperature of the laser device 12 results in control of the wavelength of the first electromagnetic signal 13. Consequently, the above technique ensures the laser device 12 emits the first electromagnetic radiation at the correct wavelength within the range of wavelengths $\Delta\lambda$.

In a second embodiment of the invention, the first embodiment is adapted so that the detector 16 comprises an array of photodiodes (not shown) upon which the second electromagnetic signal 15 is incident. The photodiodes forming the array of photodiodes are arranged, for example spaced, in such a way that high resolution detection of spacings of dispersed wavelength components of electromagnetic radiation can be detected by the detector 16.

In this example, multiple laser devices replace the laser device 12, each of the multiple laser devices being capable of generating different wavelengths of electromagnetic radiation that are multiplexed onto an optical fibre. The optical fibre is capable of supporting propagation of a number of different wavelengths of electromagnetic radiation, the number of different wavelengths of electromagnetic radiation constituting the first electromagnetic signal 13.

In operation, the first electromagnetic signal 13 comprising the number of different wavelengths of electromagnetic radiation is incident upon the photonic crystal 14, and the number of different wavelengths of electromagnetic radiation forming the first electromagnetic signal 13 are respectively dispersed by different angles and are subsequently incident upon the array of photodiodes. In this example, normal operating conditions would result in the feedback signal generated by the array of photodiodes corresponding to a spacing of 0.8 nm between the respectively dispersed different wavelengths of electromagnetic radiation. However, should one or more wavelengths of electromagnetic radiation, respectively generated by one or more delinquent laser device amongst the multiple laser devices, stray from their respective normal operating wavelengths, the array of photodiodes will detect a change from 0.8nm in one or more spacings between deviated electromagnetic radiation. This change in one or more spacing is encoded in the feedback signal used by the feedback control circuit 24 to adjust the one or more wavelengths of electromagnetic radiation respectively generated by the one or more delinquent laser device.

In a third embodiment of the invention, the first embodiment is adapted so that the detector 16 comprises a single photodiode (not shown) instead of the first and second photodiode 18, 20, and the feedback controller circuit 24 is also arranged to dither the control signal to the laser device 12. The feedback control circuit 24 is also arranged to analyse an oscillating current signal, deviation of the amplitude and phase of the oscillating current signal from respective predetermined values being indicative of a deviation of the wavelength of the first electromagnetic signal 13 from the correct wavelength within the range of wavelengths $\Delta\lambda$.

In operation, the wavelength $\lambda$ of the first electromagnetic signal 13 consequently varies slightly about a central wavelength value. The frequency of the dither of the control signal is set to be low compared to the data rate of data carried by a WDM system in which the laser wavelength locking control loop 10 is provided. The deviated second electromagnetic signal 15 incident upon the single photodiode pans to and fro across the single photodiode in an oscillatory fashion, such that the current flowing through the single photodiode has an oscillating amplitude. The feedback control circuit 24 analyses the current flowing through the single photodiode constituting the oscillating current signal in order to generate the error signal.

It should be understood that, in all of the above embodiments, it is conceivable for the power of the first electromagnetic signal 13 to change. An additional detector (not shown) and a beam splitter can therefore be provided, the beam splitter being disposed between the laser device 12 (or multiple laser devices) and the photonic crystal 14. In such an example, a first proportion of the first electromagnetic signal 13 is dispersed by the photonic crystal 14, whilst a second proportion of the first electromagnetic signal 13 is incident upon the additional detector. The additional detector monitors the power of the first electromagnetic signal 13 and generates a power monitoring signal that is used by the feedback controller circuit 24 to deconvolve the changes in power of the first electromagnetic signal 13 from the feedback signal generated by the detector 16.

It will be appreciated that the above description has been given by way of example only and that a person skilled in the art can make various modifications and improvements without departing from the scope of the present claims. For example, it is possible to manufacture the above described apparatus with varying degrees of integration, for example: the laser device 12 and the photonic crystal, the laser device 12 and the detector 16, or the laser device 12, the photonic crystal and the detector 16. In another example, if multiple currents are employed to control the wavelength of the first electromagnetic signal, the feedback controller circuit 24 can be arranged to control one or more of the multiple currents in accordance with any known technique for controlling tuneable lasers.

**Claims**

1. A control loop apparatus (10) for a laser device, the apparatus comprising a source (12) capable of emitting electromagnetic radiation (13) at a desired wavelength within a range of wavelengths, a detector (16), a dispersion element (14) disposed between the source (12) and the detector (16), and a controller (24) coupled to the source (12) and the detector (16), **characterised in that** the dispersion element (14) comprises a photonic crystal arranged to translate a change in wavelength of the electromagnetic radiation (13) from the desired wavelength into a spatial deviation of the electromagnetic radiation (13), the detector (16) being arranged to detect the spatial deviation and output a signal corresponding to a measure of the spatial deviation caused by the dispersion element (14) and the controller (24) being arranged to control a parameter of the source (13) in response to the signal generated by the detector (16) so as to maintain the electromagnetic radiation (13) substantially at the desired wavelength.

2. An apparatus as claimed in Claim 1, wherein the detector (16) comprises an array of sensors (18, 20).

3. An apparatus as claimed in Claim 1 or Claim 2, wherein the detector (16) is arranged to detect a dispersion of the electromagnetic radiation (13) by the dispersion element (14) in response to a change in the wavelength of the electromagnetic radiation (13).

4. An apparatus as claimed in any one of the preceding claims, wherein the desired wavelength of the electromagnetic radiation (13) emitted by the source (12) is capable of varying and the control of the parameter of the source (12) results in control of the desired wavelength of the electromagnetic radiation (13) emitted by the source (12).

5. A use of photonic crystal in a control loop (10) to control a wavelength of a source of electromagnetic radiation.

6. A use as claimed in claim 5, wherein the photonic crystal disperses electromagnetic radiation (13) incident thereupon, the dispersed electromagnetic radiation (15) being detectable as indicative of the wavelength of the source of electromagnetic radiation.

7. A method of controlling a source (12) capable of emitting electromagnetic radiation (13) at a desired wavelength within a range of wavelengths in a control loop (10), the control loop (10) comprising the source (12), a detector (16), a dispersion element (14) disposed between the source and the detector (16), and a controller (24) coupled to the source (12) and the detector (16), the method comprising the steps of:

causing the electromagnetic radiation (13) emitted by the source (12) to undergo a spatial deviation in response to a change in wavelength of the electromagnetic radiation (13) from the desired wavelength, detecting the spatial deviation of the electromagnetic radiation (13),

generating a signal corresponding to a measure of the spatial deviation caused by the dispersion element (14), and controlling a parameter of the source (12) in response to the signal so as to maintain the electromagnetic radiation substantially at the desired wavelength, **characterised in that** the dispersion element (14) comprises a photonic crystal.

*Fig. 1*

European Patent Office

## EUROPEAN SEARCH REPORT

Application Number

EP 01 31 0417

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | PATENT ABSTRACTS OF JAPAN vol. 2000, no. 20, 10 July 2001 (2001-07-10) -& JP 2001 075040 A (RICOH CO LTD), 23 March 2001 (2001-03-23) * paragraph '0023!; claims 1,4 * | 1,5,7 | H01S5/0687 G02B6/12 |
| X | & US 6 448 997 B1 (KOIDE) 10 September 2002 (2002-09-10) * column 4, line 9-25; claim 1; figure 3 * | 1-7 | |
| Y | PATENT ABSTRACTS OF JAPAN vol. 013, no. 159 (P-858), 18 April 1989 (1989-04-18) & JP 63 317935 A (HITACHI LTD), 26 December 1988 (1988-12-26) * abstract * | 1-7 | |
| D,Y | KOSAKA H ET AL: "SUPERPRISM PHENOMENA IN PHOTONIC CRYSTALS: TOWARD MICROSCALE LIGHTWAVE CIRCUITS" JOURNAL OF LIGHTWAVE TECHNOLOGY, IEEE. NEW YORK, US, vol. 17, no. 11, November 1999 (1999-11), pages 2032-2038, XP001033267 ISSN: 0733-8724 * page 2032, right-hand column, line 18-26; figure 1 * | 1-7 | TECHNICAL FIELDS SEARCHED (Int.Cl.7) H01S G02B H04B |
| A | WO 01 11739 A (CORETEK INC) 15 February 2001 (2001-02-15) * the whole document * | 1-7 | |
| A | US 4 917 450 A (POCHOLLE JEAN P ET AL) 17 April 1990 (1990-04-17) * figure 1 * | 1,2 | |

The present search report has been drawn up for all claims

| Place of search | Date of completion of the search | Examiner |
|---|---|---|
| THE HAGUE | 14 November 2002 | Claessen, L |

EPO FORM 1503 03.82 (P04C01)

**ANNEX TO THE EUROPEAN SEARCH REPORT
ON EUROPEAN PATENT APPLICATION NO.**          EP 01 31 0417

This annex lists the patent family members relating to the patent documents cited in the above–mentioned European search report.
The members are as contained in the European Patent Office EDP file on
The European Patent Office is in no way liable for these particulars which are merely given for the purpose of information.

14-11-2002

| Patent document cited in search report | | Publication date | Patent family member(s) | | Publication date |
|---|---|---|---|---|---|
| JP 2001075040 | A | 23-03-2001 | US | 6448997 B1 | 10-09-2002 |
| JP 63317935 0 | A | | NONE | | |
| WO 0111739 | A | 15-02-2001 | EP | 1218983 A1 | 03-07-2002 |
| | | | WO | 0111739 A1 | 15-02-2001 |
| US 4917450 | A | 17-04-1990 | FR | 2622706 A1 | 05-05-1989 |
| | | | EP | 0315512 A1 | 10-05-1989 |
| | | | JP | 1168077 A | 03-07-1989 |

EPO FORM P0459

For more details about this annex : see Official Journal of the European Patent Office, No. 12/82